# FASCICULE DE BREVET EUROPEEN

(11) **EP 2 838 849 B1**
(45) Date de publication et mention de la délivrance du brevet: **25.03.2020**
(21) Numéro de dépôt: 13719959.2
(22) Date de dépôt: 29.03.2013
(51) Int. Cl.: C01B 32/23, C01G 19/00, C01G 19/02, H01C 7/00, H01C 17/065

(54) **MATERIAU PHOTOSENSIBLE ET THERMORESISTANT, PROCEDE DE PREPARATION ET UTILISATION**
LICHTEMPFINDLICHES UND HITZEBESTÄNDIGES MATERIAL, VERFAHREN ZUR HERSTELLUNG DAVON UND VERWENDUNG DAVON
PHOTOSENSITIVE AND HEAT-RESISTANT MATERIAL, METHOD FOR PRODUCING SAME AND USE THEREOF

(30) Priorité: 20.04.2012 FR 1253653
(43) Date de publication de la demande: 25.02.2015
(73) Titulaire: Commissariat à l'Énergie Atomique et aux Énergies Alternatives, 75015 Paris (FR)
(72) Inventeur: ALIANE, Abdelkader, F-38100 Grenoble (FR); BENWADIH, Mohammed, F-94500 Champagny / Marne (FR)
(74) Mandataire: Cabinet Laurent & Charras
(86) Numéro de dépôt international: PCT/FR2013/050713
(87) Numéro de publication internationale: WO 2013/156705

(56) Documents cités:
- KR-A- 20110 113 873
- SEO TAE ET AL: "Graphene network on indium tin oxide nanodot nodes for transparent and current spreading electrode in InGaN/GaN light emitting diode", APPLIED PHYSICS LETTERS, AIP, AMERICAN INSTITUTE OF PHYSICS, MELVILLE, NY, US, vol. 98, no. 25, 24 juin 2011 (2011-06-24) , pages 251114-251114, XP012141130, ISSN: 0003-6951, DOI: 10.1063/1.3601462
- GUIHUA YU ET AL: "Solution-Processed Graphene/MnO 2 Nanostructured Textiles for High-Performance Electrochemical Capacitors", NANO LETTERS, vol. 11, no. 7, 13 juillet 2011 (2011-07-13), pages 2905-2911, XP055052335, ISSN: 1530-6984, DOI: 10.1021/nl2013828
- LIM H N ET AL: "Preparation and characterization of tin oxide, SnOnanoparticles decorated graphene", CERAMICS INTERNATIONAL, ELSEVIER, AMSTERDAM, NL, vol. 38, no. 5, 1 février 2012 (2012-02-01), pages 4209-4216, XP028409766, ISSN: 0272-8842, DOI: 10.1016/J.CERAMINT.2012.02.004 [extrait le 2012-02-09]

## Description

### DOMAINE DE L'INVENTION

La présente invention concerne un matériau photosensible et thermorésistant à base de graphène et d'oxyde d'étain. Le domaine d'utilisation de l'invention comprend les applications tactiles, telles que notamment mises en œuvre dans les écrans, les claviers, les pavés tactiles, etc.

### ETAT ANTERIEUR DE LA TECHNIQUE

La résistivité des matériaux photorésistants, ou photosensibles, varie en fonction de la quantité de lumière incidente. En d'autres termes, la résistance diminue lorsque la lumière incidente augmente.

Les matériaux photorésistants de l'art antérieur comprennent généralement des éléments des groupes II à VI de la classification périodique des éléments. Par exemple, le sulfure de cadmium (CdS) ou le séléniure de cadmium (CdSe) sont couramment utilisés dans les applications dans le domaine visible, notamment en raison de leur faible coût. En revanche, ces matériaux sont généralement inaptes pour les applications dans l'infrarouge. Dans ce cas, le sulfure de plomb (PbS) peut alors être utilisé.

En outre, les matériaux de l'art antérieur présentent de nombreux inconvénients parmi lesquels on peut citer leur manque de stabilité dans le temps, ou leur temps de réponse relativement long lorsque la luminosité varie.

Quant aux matériaux thermorésistants, leur résistance ou résistivité varie en fonction de la température. Ces matériaux peuvent être à base de métaux ou d'oxydes métalliques. Contrairement aux photorésistances, les thermorésistances sont généralement stables dans le temps.

Seo et al. (Applied Physics Letters, 2011, 98, 251114) ont décrit un multicouche comprenant une couche à base d'ITO, sur laquelle est déposé du graphène. YU et al. (Nano letters, 2011, vol. 11, n° 7, pages 2905-2911) ont décrit la préparation d'un matériau hybride graphène / MnO₂ par voie liquide. Le document KR 2011-0113873 décrit un film à base de nanotubes de carbone ou de graphène, de polymère conducteur et d'un oxyde.

Le matériau mis au point par le Demandeur peut capter dans le spectre visible ainsi que dans le proche infrarouge. En outre, il présente une résistance électrique qui diminue en fonction de la quantité de rayonnement captée. Ce matériau permet également de détecter les variations de chaleur pouvant se traduire par des variations du rayonnement proche infrarouge émis par le doigt dans le cadre d'une application tactile.

### EXPOSE DE L'INVENTION

Le Demandeur a mis au point un nouveau matériau photorésistant et thermorésistant à base d'étain et de carbone.

Contrairement au graphène, ce matériau présente le double avantage d'une part, d'être sensible à un large spectre de rayonnement, notamment aux longueurs d'onde du spectre visible et du spectre proche infrarouge, et d'autre part, de présenter une résistance électrique qui diminue en fonction de la quantité de rayonnement collectée. Dans le cadre d'une application tactile, il pourrait notamment s'agir d'un doigt, qui émet une quantité importante de rayonnement infrarouge. La variation du rayonnement photosensible peut ainsi être détectée même si la lumière visible ambiante est très faible.

Plus précisément, la présente invention concerne un matériau à base d'étain comprenant :
- 100 à 50 parts en poids de graphène ;
- 0 à 50 parts en poids de dioxyde d'étain dopé par de l'antimoine (ATO) ;
- 0 à 50 parts en poids de dioxyde d'étain dopé par de l'indium (ITO) ; ledit matériau étant un mélange comprenant au moins de l'ATO et/ou du ITO, ledit matériau comprenant des liasons entre ses constituants.

Le matériau objet de l'invention comprend ainsi du graphène, et de l'ATO et/ou de l'ITO. En d'autres termes, ledit matériau comprend nécessairement du graphène, mais également au moins de l'ATO et/ou de l'ITO.

Pour plus de clarté, il est précisé que les quantités exprimées en termes de parts en poids ont avantageusement pour référence une quantité comprise entre 100 et 200 parts en poids de matériau à base d'étain. En d'autres termes, le matériau à base d'étain comprend avantageusement, pour 100 à 200 parts en poids de matériau :
- 100 à 50 parts en poids de graphène ;
- 0 à 50 parts en poids de dioxyde d'étain dopé par de l'antimoine (ATO) ;
- 0 à 50 parts en poids de dioxyde d'étain dopé par de l'indium (ITO).

La présence d'étain par incorporation de dioxyde d'étain dopé soit par de l'antimoine, soit par de l'indium, permet de moduler la sensibilité du matériau, que ce soit en termes de sensibilité de détection à la lumière ou de variation de la résistance en fonction de la température. L'homme du métier saura donc ajuster les quantités respectives selon l'utilisation finale du matériau.

Toutefois, selon un mode de réalisation préféré, le matériau comprend entre 10 et 20 parts en poids d'ATO et/ou d'ITO pour 80 à 90 parts en poids de graphène.

Selon un autre mode de réalisation particulier, le matériau à base d'étain comprend 20 parts en poids d'ATO et/ou d'ITO et 80 parts en poids de graphène, avantageusement pour 100 parts en poids de matériau.

Le matériau objet de l'invention comprend des liaisons entre ses constituants. Ainsi, sans émettre une quelconque hypothèse, il est possible que ses propriétés de thermorésistance et de photorésistance résultent de la présence de ces liaisons.

Le graphène est un cristal bidimensionnel de carbone. L'empilement tridimensionnel de couches de graphène constitue le graphite.

Le dioxyde d'étain dopé par de l'antimoine (ATO) présente un rapport en poids Sn/Sb avantageusement compris entre 5 et 10. La formule de l'ATO est avantageusement SnO₂ : Sb₂O₃, ou SnO₂ : Sb₂O₅. De manière encore plus avantageuse, il s'agit du SnO₂ : Sb₂O₃.

S'agissant du dioxyde d'étain dopé par de l'indium (ITO), il présente un rapport en poids Sn/In avantageusement compris entre 5 et 10. l'ITO correspond avantageusement à la formule SnO₂ : In₂O₃ ou SnO₂ : In₂O₅. De manière encore plus avantageuse, il s'agit du SnO₂ : In₂O₃.

De manière générale, dans le matériau à base d'étain - objet de l'invention, le rapport en poids graphène/ATO et/ou ITO est compris entre 1 et 5, encore plus avantageusement entre 3 et 4. En d'autres termes, dans le matériau, le poids du graphène représente entre 1 et 5 fois le poids de l'ATO et/ou de l'ITO, et plus avantageusement entre 3 et 4 fois. Selon un mode de réalisation particulier, ce rapport peut être égal à 4.

De manière avantageuse, le matériau - objet de l'invention comprend soit de l'ATO, soit de l'ITO.

En outre, selon un mode de réalisation particulier, le matériau - objet de l'invention peut comprendre des nanoparticules métalliques, et/ou semi conductrices.

Les nanoparticules, selon leurs propriétés conductrices, peuvent permettre de moduler la conductivité électrique du matériau - objet de la présente invention.

En outre, les nanoparticules, et plus particulièrement les nanoparticules d'oxydes métalliques ou semi conductrices sont très sensibles à la lumière, elles peuvent ainsi contribuer à moduler l'absorption optique du matériau.

De manière avantageuse mais en aucun cas limitative, ces nanoparticules peuvent présenter une forme sphérique et un diamètre compris entre 10 et 100 nanomètres, encore plus avantageusement entre 20 et 50 nanomètres.

Toutefois, l'homme du métier saura adapter leur forme et leur taille en fonction des propriétés recherchées de manière à moduler les performances du matériau, notamment dans le but d'augmenter la sensibilité du matériau à la lumière.

Selon un mode de réalisation préféré, les nanoparticules consistent en un mélange de nanoparticules métalliques et de nanoparticules d'oxydes métalliques, représentant entre 1 et 10 parts en poids par rapport au poids du matériau. Il peut notamment s'agir de nanoparticules choisies dans le groupe comprenant les nanoparticules d'argent, In₂O₃, InZnO, ZnO, CuO, NiO, et leurs mélanges.

Selon un autre mode de réalisation préféré, les nanoparticules consistent en un mélange de nanoparticules métalliques et de nanoparticules semi conductrices, représentant entre 1 et 5 parts en poids par rapport au poids du matériau. Il peut notamment s'agir d'un mélange de nanoparticules d'argent, et de InGaZnO.

Ainsi, la résistance électrique peut être modulée afin d'améliorer la sensibilité de la détection.

La présente invention concerne également un procédé de préparation du matériau à base de graphène et d'ATO et/ou d'ITO décrit ci-avant, selon les étapes suivantes :
- préparation d'une encre de graphène ;
- préparation d'une encre de dioxyde d'étain dopé avec de l'antimoine et/ou de l'indium ;
- addition de l'encre de graphène et de l'encre de dioxyde d'étain dopé avec de l'antimoine et/ou de l'indium ;
- addition, le cas échéant, d'un mélange de nanoparticules métalliques et de nanoparticules d'oxydes métalliques ou d'un mélange de nanoparticules métalliques et de nanoparticules semi conductrices ;
- agitation du mélange obtenu, de préférence à une température comprise entre 30 et 60 °C ;
- séchage du mélange, avantageusement par évaporation des solvants, pour donner le matériau à base de graphène et d'ATO et/ou d'ITO.

Dans le cas de la préparation d'un matériau comprenant de l'ATO et de l'ITO, l'encre à base de dioxyde d'étain peut comprendre de l'ATO et de l'ITO. Selon un autre mode de réalisation, deux encres distinctes pourront être préparées, et ajoutées simultanément ou non.

L'agitation du mélange est avantageusement mécanique, et permet d'homogénéiser ledit mélange.

Selon un mode de réalisation particulier, l'encre à base de dioxyde d'étain peut comprendre entre 60 et 80 % en poids d'ATO et/ou d'ITO dispersés dans au moins un solvant. Le solvant peut être choisi dans le groupe comprenant notamment la cyclopentanone, l'acétate d'éthyle, le tétrahydrofurane, la 3-hexanone, la 2-pentanone.

D'autre part, l'encre de graphène peut comprendre entre 40 et 80 % en poids de graphène dispersés dans au moins un solvant. Le solvant peut être notamment la cyclohexanone, la cyclopentanone.

Toutefois, les différentes encres mises en œuvre dans le cadre de l'invention peuvent également être à base de solutions aqueuses.

En outre, l'homme du métier saura ajuster les concentrations respectives des encres de graphène et d'ATO et/ou d'ITO. Les valeurs précisées ci-avant sont indicatives et ne sauraient en aucun cas limiter l'invention.

La présente invention concerne également une photorésistance et une thermorésistance comprenant le matériau décrit ci-avant.

La préparation de la photorésistance ou de la thermorésistance - objets de l'invention, est mise en œuvre notamment par dépôt sur un substrat du mélange comprenant l'encre d'ATO et/ou d'ITO, l'encre de graphène et éventuellement des nanoparticules.

Avantageusement, le substrat est constitué d'un matériau au moins partiellement transparent à la lumière visible. Il peut donc s'agir de PEN (poly(éthylène 2,6-naphthalate)), ou de PET (polyéthylène téréphtalate). Ce type de substrat présente le triple avantage d'être flexible, transparent au spectre visible et au proche infrarouge et d'être peu onéreux.

En outre, le substrat peut avantageusement présenter une épaisseur comprise entre 25 micromètres et 200 micromètres.

Quant au dépôt du mélange comprenant le matériau photorésistant et/ou thermorésistant, il peut être réalisé par sérigraphie, par jet d'encre, ou par toute autre technique de dépôt connue de l'homme du métier.

L'épaisseur du dépôt peut être comprise entre 100 nanomètres et plusieurs micromètres. L'homme du métier saura ajuster cette épaisseur en fonction de l'application visée.

Le dépôt du mélange est avantageusement suivi d'une étape de recuit qui peut être réalisé à une température comprise entre 100 et 120 °C, pendant une durée comprise entre 10 et 60 minutes. L'homme du métier saura ajuster les conditions (durée et température) en fonction du substrat, de l'épaisseur du dépôt, et autres paramètres.

De manière générale, les solvants de l'encre de graphène et de l'encre d'ATO et/ou d'ITO ont avantageusement une température d'évaporation proche l'une de l'autre afin de former une couche déposée très uniforme. Ces températures d'évaporation sont également avantageusement compatibles avec la température de recuit. Notamment, les températures d'évaporation peuvent être avantageusement comprises entre 110 et 180 °C.

L'étape de recuit permet notamment d'éliminer les solvants présents dans les encres mises en œuvre pour préparer la photorésistance ou la thermorésistance.

Comme déjà indiqué, le matériau à base d'étain objet de l'invention comprend du graphène, et de l'ATO et/ou de l'ITO. En d'autres termes, ledit matériau comprend nécessairement du graphène, mais également au moins de l'ATO ou de l'ITO. Le matériau comprend une quantité non nulle d'ATO ou d'ITO. Ainsi, lorsque le matériau comprend 0 part d'ITO, il comprend nécessairement x parts d'ATO, avec 0 < x ≤ 50.

De la même manière, lorsque le matériau comprend 0 part d'ATO, il comprend nécessairement y parts d'ITO, avec 0 < y ≤ 50.

Pour 100 à 200 parts en poids de matériau, ledit matériau comprend avantageusement :
- 100 à 50 parts en poids de graphène ;
- 0 ≤ x ≤ 50 parts en poids de dioxyde d'étain dopé par de l'antimoine (ATO) ;
- 0 ≤ y ≤ 50 parts en poids de dioxyde d'étain dopé par de l'indium (ITO) ; lorsque x + y est différent de 0.

Selon un mode de réalisation particulier, x + y peut être égal à 5, 10, 15, 20, 25, 30, 35, 40, 45, 50, 55, 60, 65, 70, 75, 80, 85, 90, 95, ou 100, avec x + y ≠ 0. x + y peut être compris entre deux de ces valeurs. Par exemple, x + y peut ainsi être compris entre 5 et 100, entre 10 et 50, ou entre 10 et 85.

L'invention et les avantages qui en découlent ressortiront mieux des figures et exemples suivants donnés afin d'illustrer l'invention et non de manière limitative.

### DESCRIPTION DES FIGURES

La figure 1 illustre la résistance du matériau objet de l'invention en fonction de son exposition à la lumière visible du jour.
La figure 2 représente la variation de la résistance en fonction de la température pour un matériau comprenant 50% en poids de graphène et 50% en poids d'ATO.

### EXEMPLES DE REALISATION DE L'INVENTION

### Préparation du matériau photorésistant et thermorésistant selon l'invention

Une encre de graphène est préparée en dispersant 6 g de graphène (de chez VORBECK) dans 10 ml de cyclopentanone par exemple.

Parallèlement, une encre d'ATO est préparée en dispersant 6 g d'ATO (de chez DUPONT) dans 10 ml de cyclopentanone.

Les encres de graphène et d'ATO sont ensuite mélangées afin d'obtenir un rapport en poids graphène/ATO de 4.

A ce mélange sont ensuite ajoutés de 0 à 10 mg d'un mélange de nanoparticules de d'argent, In₂O₃, InZnO, ZnO, CuO, NiO ou des nanoparticules d'argent, et de InGaZnO selon un autre mode de réalisation.

Le mélange résultant est ensuite agité mécaniquement à une température de 60 °C.

La solution obtenue est ensuite séchée par évaporation des solvants à 100 °C, sous air.

### Préparation d'une photorésistance ou d'une thermorésistance selon l'invention

Le mélange obtenu ci-dessus est déposé, avant évaporation des solvants, sur un substrat par sérigraphie.

Le substrat en PEN présente une épaisseur de 125 micromètres alors que 5 micromètres de mélange ont été déposés.

Après dépôt du mélange, un recuit est réalisé à une température de 100 °C pendant 20 minutes.

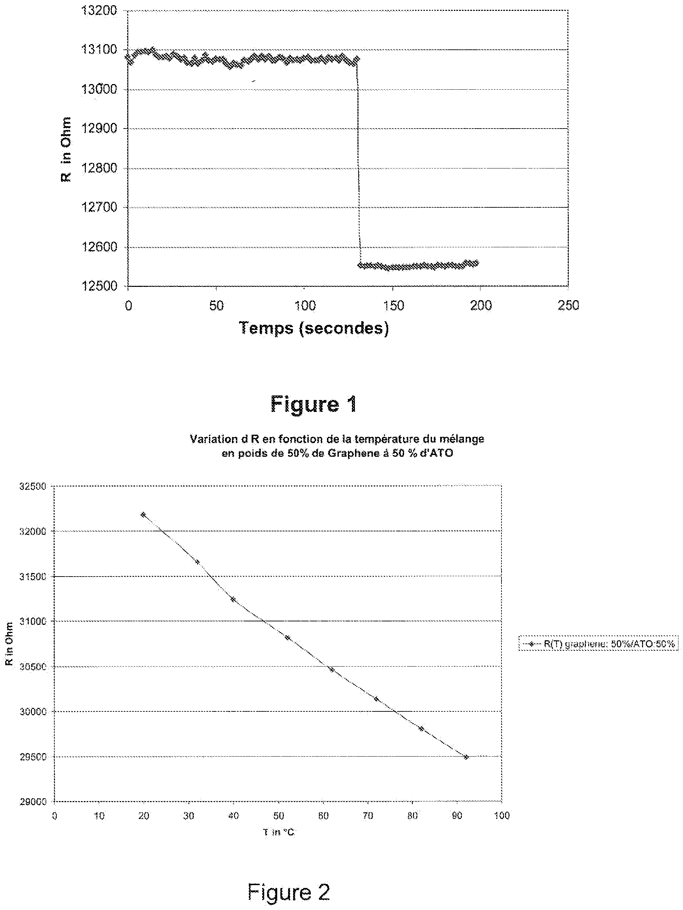

Les propriétés de photosensibilité de cette photorésistance sont illustrées par la figure 1. En effet, la résistance de ce matériau varie de près de 13000 ohm lorsqu'elle n'est pas exposée à la lumière à 12000 ohm lorsqu'elle est exposée à la lumière du jour. Le temps de réaction de ce matériau est extrêmement bref, de l'ordre de 1 microseconde à 10 ms.

La variation de la résistance de ce matériau en fonction de la température est illustrée par la figure 2. La résistance du matériau diminue régulièrement en même temps que la température augmente. Alors que la résistance du matériau est supérieure à 32000 ohm à 20 °C, elle est égale à 29500 ohm à 90 °C.

## Revendications

1. Matériau à base d'étain comprenant :
- 50 à 100 parts en poids de graphène ;
- 0 à 50 parts en poids de dioxyde d'étain dopé par de l'antimoine (ATO) ;
- 0 à 50 parts en poids de dioxyde d'étain dopé par de l'indium (ITO) ; ledit matériau étant un mélange comprenant au moins de l'ATO et/ou de l'ITO, ledit matériau comprenant des liaisons entre ses constituants.

2. Matériau selon la revendication 1, ***caractérisé* en ce qu'**il comprend en outre entre 1 et 10 parts en poids d'un mélange de nanoparticules métalliques et de nanoparticules d'oxydes métalliques.

3. Matériau selon la revendication 2, ***caractérisé* en ce que** le mélange comprend des nanoparticules choisies dans le groupe comprenant les nanoparticules d'argent, In₂O₃, InZnO, ZnO, CuO, NiO, et leurs mélanges.

4. Matériau selon la revendication 1, ***caractérisé* en ce qu'**il comprend en outre entre 1 et 5 parts en poids d'un mélange de nanoparticules métalliques et de nanoparticules semi conductrices.

5. Matériau selon la revendication 4, ***caractérisé* en ce que** le mélange comprend des nanoparticules d'argent, et de InGaZnO.

6. Matériau selon l'une des revendications précédentes, ***caractérisé* en ce que** le rapport en poids entre le graphène et l'ATO et/ou l'ITO est compris entre 1 et 5.

7. Matériau selon l'une des revendications précédentes, ***caractérisé* en ce que** le rapport en poids entre le graphène et l'ATO et/ou l'ITO est compris entre 3 et 4.

8. Matériau selon l'une des revendications précédentes, ***caractérisé* en ce que** l'ATO et l'ITO présentent respectivement un rapport en poids Sn/Sb et Sn/In compris entre 5 et 10.

9. Matériau selon l'une des revendications précédentes, ***caractérisé* en ce que** l'ATO correspond à la formule SnO₂:Sb₂O₃, ou SnO₂:Sb₂O₅.

10. Matériau selon l'une des revendications précédentes, ***caractérisé* en ce que** l'ITO correspond à la formule SnO₂:In₂O₃ ou SnO₂:In₂O₅.

11. Procédé de préparation du matériau à base de graphène et d'ATO et/ou d'ITO objet des revendications 1 à 10, selon les étapes suivantes :
- préparation d'une encre de graphène ;
- préparation d'une encre d'ATO et/ou d'ITO ;
- addition de l'encre de graphène et de l'encre d'ATO et/ou d'ITO ;
- addition, le cas échéant, d'un mélange de nanoparticules métalliques et de nanoparticules d'oxydes métalliques ou d'un mélange de nanoparticules métalliques et de nanoparticules semi conductrices ;
- agitation du mélange obtenu ;
- séchage du mélange pour donner le matériau à base de graphène et d'ATO et/ou d'ITO.

12. Procédé selon la revendication 11, ***caractérisé* en ce que** l'agitation du mélange obtenu est réalisée à une température comprise entre 30 et 60 °C.

13. Procédé selon la revendication 11, ***caractérisé* en ce que** le séchage du mélange, est réalisé par évaporation des solvants.

14. Photorésistance comprenant le matériau objet de l'une des revendications 1 à 10.

15. Thermorésistance comprenant le matériau objet de l'une des revendications 1 à 10.

## Patentansprüche

1. Material auf Zinnbasis, umfassend:
- zwischen 50 und 100 Gewichtsanteile Graphen;
- zwischen 0 und 50 Gewichtsanteile von mit Antimon (ATO) dotiertem Zinndioxid;
- zwischen 0 und 50 Gewichtsanteile von mit Indium (ITO) dotiertem Zinndioxid;
wobei es sich bei dem Material um eine Mischung handelt, die mindestens ATO und/oder ITO umfasst, wobei dieses Material dabei Verbindungen zwischen seinen Bestandteilen enthält.

2. Material nach Anspruch 1, ***dadurch gekennzeichnet, dass*** es außerdem zwischen 1 und 10 Gewichtsanteile einer Mischung aus Metall-Nanopartikeln und Metalloxid-Nanopartikeln enthält.

3. Material nach Anspruch 2, ***dadurch gekennzeichnet, dass*** die Mischung Nanopartikel enthält, die zur Gruppe der Nanopartikeln von Silber, In₂O₃, InZnO, ZnO, CuO, NiO und ihrer Mischungen gehören.

4. Material nach Anspruch 1, ***dadurch gekennzeichnet, dass*** es außerdem zwischen 1 und 5 Gewichtsanteile aus Metall-Nanopartikeln und Halbleiter-Nanopartikeln enthält.

5. Material nach Anspruch 4, ***dadurch gekennzeichnet, dass*** die Mischung Silber-Nanopartikel und InGaZnO enthält.

6. Material nach einem der vorangehenden Ansprüche, ***dadurch gekennzeichnet, dass*** das Gewichtsverhältnis zwischen dem Graphen und dem ATO und/ oder dem ITO zwischen 1 und 5 liegt.

7. Material nach einem der vorangehenden Ansprüche, ***dadurch gekennzeichnet, dass*** das Gewichtsverhältnis zwischen dem Graphen und dem ATO und/ oder dem ITO zwischen 3 und 4 liegt.

8. Material nach einem der vorangehenden Ansprüche, ***dadurch gekennzeichnet, dass*** das ATO und das ITO jeweils ein Gewichtsverhältnis Sn/Sb und Sn/In zwischen 5 und 10 aufweisen.

9. Material nach einem der vorangehenden Ansprüche, ***dadurch gekennzeichnet, dass*** das ATO der Formel SnO₂:Sb₂O₃ oder SnO₂:Sb₂O₅ entspricht.

10. Material nach einem der vorangehenden Ansprüche, ***dadurch gekennzeichnet, dass*** das ITO der Formel SnO₂:In₂O₃ oder SnO₂:InO₅ entspricht.

11. Verfahren zur Herstellung eines Materials auf Basis von Graphen und ATO und/ oder ITO, Gegenstand der Ansprüche 1 bis 10, in den folgenden Schritten:
- Herstellung einer Graphentinte;
- Herstellung einer ATO- und/ oder ITO-Tinte;
- Zugabe der Graphentinte und der ATO- und/ oder ITO-Tinte;
- gegebenenfalls Zugabe einer Mischung aus Metall-Nanopartikeln und Metalloxid-Nanopartikeln oder einer Mischung aus Metall-Nanopartikeln und Halbleiter-Nanopartikeln;
- Schütteln der erhaltenen Mischung;
- Trocknen der Mischung, um das Material auf Basis von Graphen und ATO und/ oder ITO zu ergeben.

12. Verfahren nach Anspruch 11, ***dadurch gekennzeichnet, dass*** das Schütteln der Mischung bei einer Temperatur zwischen 30 und 60 °C erfolgt.

13. Verfahren nach Anspruch 11, ***dadurch gekennzeichnet, dass*** das Trocknen der Mischung durch Verdampfen der Lösungsmittel erfolgt.

14. Photowiderstand mit dem Material nach einem der Ansprüche 1 bis 10.

15. Wärmewiderstand mit dem Material nach einem der Ansprüche 1 bis 10.

## Claims

1. A tin-based material, comprising:
- from 50 to 100 wt. parts of graphene;
- from 0 to 50 wt. parts of antimony-doped tin dioxide (ATO);
- from 0 to 50 wt. parts of indium-doped tin dioxide (ITO);
said material is a mixture comprising at least ATO and/or ITO,
said material comprising bonds between its components.

2. The material of claim 1, ***characterized* in that** it further comprises from 1 to 10 wt. parts of a mixture of metal nanoparticles and of metal oxide nanoparticles.

3. The material of claim 2, ***characterized* in that** the mixture comprises nanoparticles selected from the group comprising silver, In₂O₃, InZnO, ZnO, CuO, NiO nanoparticles, and mixtures thereof.

4. The material of claim 1, ***characterized* in that** it further comprises from 1 to 5 wt. parts of a mixture of metal nanoparticles and of semiconductor nanoparticles.

5. The material of claim 4, ***characterized* in that** the mixture comprises silver and InGaZnO nanoparticles.

6. The material of any of the foregoing claims, ***characterized* in that** the weight ratio between graphene and ATO and/or ITO is in the range from 1 to 5.

7. The material of any of the foregoing claims, ***characterized* in that** the weight ratio between graphene and ATO and/or ITO is in the range from 3 to 4.

8. The material of any of the foregoing claims, ***characterized* in that** the ATO and the ITO respectively have a Sn/Sb and Sn/In weight ratio in the range from 5 to 10.

9. The material of claim 1, ***characterized* in that** the ATO corresponds to formula SnO₂:Sb₂O₃, or SnO₂:Sb₂O₅.

10. The material of claim 1, ***characterized* in that** the ITO corresponds to formula SnO₂:In₂O₃, or SnO₂:In₂O₅.

11. A method of preparing the material based on graphene and ATO and/or ITO of claims 1 to 10, according to the steps of:
- preparing a graphene ink;
- preparing an ATO and/or ITO ink;
- adding the graphene ink and the ATO and/or ITO ink;
- adding, if need be, a mixture of metal nanoparticles and of metal oxide nanoparticles or a mixture of metal nanoparticles and of semiconductor nanoparticles;
- stirring the obtained mixture;
- drying the mixture to provide the material based on graphene and on ATO and/or ITO.

12. The method of claim 11, ***characterized* in that** the stirring of the obtained material is performed at a temperature in the range from 30 to 60°C.

13. The method of claim 11, ***characterized* in that** the drying of the mixture is performed by evaporating the solvents.

14. A photoresistor comprising the material of any of claims 1 to 10.

15. A thermistor comprising the material of any of claims 1 to 10.
